# EUROPÄISCHE PATENTANMELDUNG

(11) **EP 2 700 956 A2**
(43) Veröffentlichungstag der Anmeldung: **26.02.2014**
(21) Anmeldenummer: 13178187.4
(22) Anmeldetag: 26.07.2013
(51) Int. Cl.: G01R 15/18

(54) **Stromwandler und Strommessvorrichtung**

(30) Priorität: 23.08.2012 CN 201210303118
(71) Anmelder: Siemens Aktiengesellschaft, 80333 München (DE)
(72) Erfinder: Wu, Di, 200122 Shanghai (CN); Lu, Xiang Dong, 201514 Shanghai (DE); Bao, Zhang Yao, 93049 Regensburg (DE)

(57) **Zusammenfassung**

Die vorliegende Erfindung betrifft einen Stromwandler (1), der einen Magnetkern (5) und wenigstens eine um den Magnetkern (5) gewundene Erregerwicklung (3) umfasst, wobei das Verhältnis der Quadratwurzel des Querschnitts des Magnetkerns (5) zur Länge des Magnetkreises des Magnetkerns (5) nicht größer ist als 0,02. Die Querschnittsfläche Ac des Magnetkerns wird auf ein festgelegtes Ausmaß verringert, wenn die Erregungsfrequenz f beibehalten wird und sich nicht ändert, kann mittels einer Erhöhung der Spulenwindungszahl N oder einer Verringerung der Erregungsspannung Vext eine Senkung des Stromverbrauchs im System erreicht werden; wenn die Spulenwindungszahl N beibehalten wird und sich nicht ändert, kann die Erregungsfrequenz f erhöht werden, somit erweitert sich der Messumfang der Frequenz im System, derart können der Messumfang der Stromstärke oder der Messumfang der Frequenz erweitert werden.

## Beschreibung

### Technisches Gebiet

Die vorliegende Erfindung betrifft einen Stromwandler sowie eine den Stromwandler nutzende Strommessvorrichtung; insbesondere betrifft sie einen Stromwandler, der einen Magnetkern und wenigstens eine um den Magnetkern gewundene Erregerwicklung umfasst, sowie eine den Stromwandler nutzende Strommessvorrichtung.

### Stand der Technik

Vergleicht man die Magnetmodulationstechnologie-Strommesstechnologie mit herkömmlichen Wechselstromwandler-Messverfahren, weist sie den Vorteil einer stärkeren Wellentyp-Flexibilität auf, deshalb wird sie in vielen unterschiedlichen Bereichen umfassend eingesetzt. Weil bei dieser Technologie die Erregung aufrecht erhalten werden muss, erfährt der Messumfang der Stromstärke aufgrund von Anforderungen wie Stromverbrauch und Messfrequenz etc. Einschränkungen.

Bei Strommessprodukten des Stands der Technik wird in erster Linie mittels Verbesserung der magnetischen Eigenschaften des Wandler-Magnetkerns die für den Messeinheit-Reststrom benötigte Energie gesenkt.

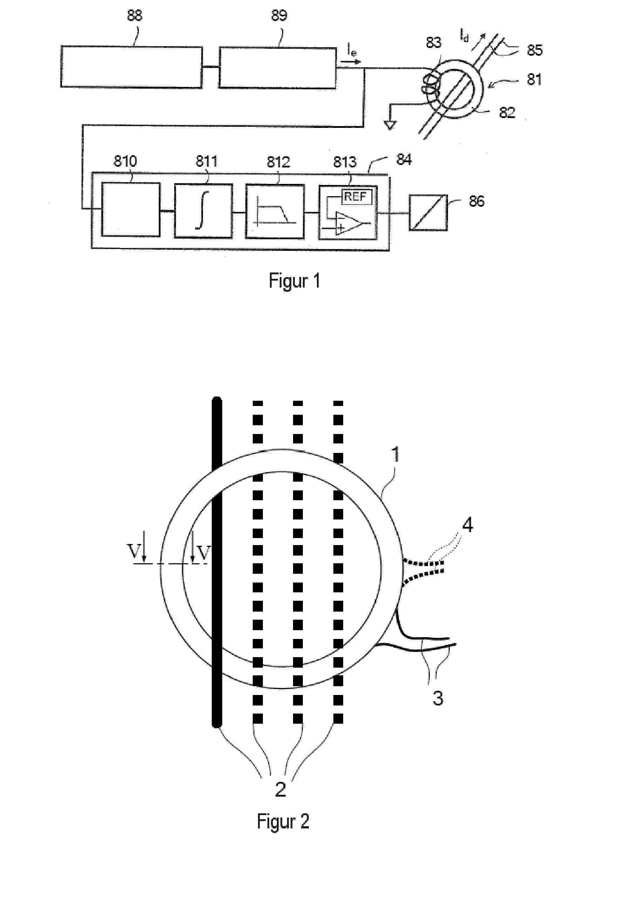

Wie in Zeichnung 1 dargestellt, betrifft die Patentanmeldung ZA200203953 A einen Wandler zur Messung von Erdschluss, dieser Wandler 82 besteht aus vorwiegend eisenhaltigem magnetischem Material mit einer Körnchengröße von weniger als 100 nm, und verfügt über magnetische Eigenschaften wie eine deutliche rechteckige B-H-Kurve sowie eine Koerzitivkraft von weniger als 3 A/m. Mittels Verbesserungen der magnetischen Eigenschaften des Stromwandler-Eisenkerns, wie sie in der vorliegenden Anmeldung beschrieben werden, kann der Eisenverlust im Magneterregungsprozess effektiv verringert werden, und somit der Stromverbrauch im System gesenkt werden.

Obwohl durch eine Verbesserung der magnetischen Eigenschaften des Eisenkerns die Beschädigung effektiv verringert werden kann, stellt der Eisenverlust keinesfalls den wichtigsten Energieverlust im System dar. Weil im Verarbeitungskreislauf 84 mittels Tiefpass 812 die magnetische Erregungsfrequenz herausgefiltert wird, muss die magnetische Erregungsfrequenz deutlich höher sein als die Frequenz der zu messenden Stromstärke. Je höher die vom Erregungskreislauf 89 abgegebene Stromspannung ist, desto höher ist auch die Erregungsfrequenz, und desto leichter wird das Erregungssignal gefiltert, deshalb muss die Ausgangsspannung des Erregungskreislaufs 89 höher sein als ein bestimmter Wert, um eine ausreichende Erregungsfrequenz zu gewährleisten. Außerdem muss, um zu garantieren, dass die Ausgabe des Erregungskreislaufs einen ausreichend dynamischen Umfang hat, ein Stromwert mit nicht identischen Reaktionen verwendet werden, und die Eingangsspannung des Erregungskreislaufs 89 größer sein als ein bestimmter Wert, dieser Wert steht in linearer Beziehung zur Feststellbarkeit des größten Spitzenstroms des Magnetmodulationssystems.

Zusammenfassend lässt sich sagen, dass die Eingangsspannung des Erregungskreislaufs 89 ausreichend hoch sein muss, um Größe und Frequenz der Stromstärke in ausreichendem Umfang messen zu können. Da im Erregungskreislauf 89 eine lineare Antriebsvorrichtung enthalten ist, kann eine Erhöhung der Stromspannung dazu führen, dass sich der Stromverbrauch erhöht. Wenn der zu messende Stromwert relativ hoch ist, ist der Verbrauch der Energie an der Antriebsvorrichtung weitaus größer als der Eisenverlust. Eine Verbesserung der magnetischen Eigenschaften des Wandlers 82 kann den Systemverlust nur verbessern, wenn die zu messende Stromstärke Null beträgt oder relativ gering ist, der Systemverbrauch bei zu messender großer Stromstärke stellt keinesfalls eine wesentliche Verbesserung dar, der Messumfang von Größe und Frequenz der zu messenden Stromstärke unterliegt immer noch großen Einschränkungen in Bezug auf den Verbrauch.

### Gegenstand der Erfindung

Ziel der vorliegenden Erfindung ist die Bereitstellung eines Stromwandlers, der den Messumfang der Stromstärke oder der Frequenz erweitern kann.

Das andere Ziel der vorliegenden Erfindung ist die Bereitstellung einer Strommessvorrichtung, die den Messumfang der Stromstärke oder der Frequenz erweitern kann.

Die vorliegende Erfindung liefert einen Stromwandler, der einen Magnetkern und wenigstens eine um den Magnetkern gewundene Erregerwicklung umfasst, wobei das Verhältnis der Quadratwurzel des Querschnitts des Magnetkerns zur Länge des Magnetkreises des Magnetkerns nicht größer ist als 0,02.

Die Querschnittsfläche Ac des Magnetkerns wird auf ein festgelegtes Ausmaß verringert, wenn die Erregungsfrequenz f beibehalten wird und sich nicht ändert, kann mittels einer Erhöhung der Spulenwindungszahl N oder einer Verringerung der Erregungsspannung Vext eine Senkung des Stromverbrauchs im System erreicht werden; wenn die Spulenwindungszahl N beibehalten wird und sich nicht ändert, kann die Erregungsfrequenz f erhöht werden, somit erweitert sich der Messumfang der Frequenz im System, derart können der Messumfang der Stromstärke oder der Messumfang der Frequenz schrittweise erweitert werden.

In einem Ausführungsbeispiel der vorliegenden Erfindung ist der Magnetkern aus einer Legierung hergestellt, und die Legierung umfasst wenigstens Nickel und Eisen, wobei der Nickelgehalt wenigstens 30 % des Gesamtgewichts des Magnetkerns ausmacht. Durch die Wahl eines solchen Magnetkernmaterials kann die gesättigte magnetische Flussdichte Bm verringert werden, somit wird der Messumfang der Stromstärke oder der Messumfang der Frequenz schrittweise erweitert. Außerdem ist die Biegsamkeit des oben erwähnten Legierungsmaterials vergleichsweise gut, was für die Herstellung von Magnetkernen mit einer Querschnittsfläche, die kleiner ist als die von herkömmlichen Magnetkernen des Stands der Technik, vorteilhaft ist.

In einem Ausführungsbeispiel der vorliegenden Erfindung umfasst der Stromwandler weiterhin eine Halterung, diese Halterung befindet sich zwischen dem Magnetkern und der Erregerwicklung, diese Halterung verfügt über einen Aufnahme-Zwischenraum, und der Magnetkern befindet sich in diesem Aufnahme-Zwischenraum. Die Halterung kann dazu verwendet werden, die Erregerwicklung zu stützen, und kann gleichzeitig den Magnetkern fixieren.

In einem Ausführungsbeispiel der vorliegenden Erfindung befindet sich zwischen Magnetkern und der Halterung zur Abdichtung noch Abdichtmaterial, zum Beispiel Material wie Harz oder Gummi oder Ähnliches, um zu verhindern, dass der Magnetkern im Wandler schwankt.

In einem Ausführungsbeispiel der vorliegenden Erfindung befindet sich außerhalb der Erregerwicklung zur Abdeckung noch ein Gehäuse, das verwendet wird, um den Wandler vor Störungen von außen abzuschirmen.

In einem Ausführungsbeispiel der vorliegenden Erfindung ist noch eine Messwicklung enthalten, die verwendet wird, damit der Wandler ein Messsignal übermittelt, um somit zu überprüfen, ob der Wandler ordnungsgemäß funktionieren kann.

In einem Ausführungsbeispiel der vorliegenden Erfindung verfügt der Wandler über eine kreisrunde Struktur oder eine quadratische Struktur, Wandler mit einer solchen Struktur sind relativ weit verbreitet.

Die vorliegende Erfindung liefert weiterhin eine Strommessvorrichtung, umfasst der Stromwandler weiterhin eine Messwicklung, wobei wenigstens ein stromführender Leiter das Innere des Wandlers durchläuft, und die Messvorrichtung weiterhin einen Erregungs- und Überwachungsstromkreis umfasst, wobei ein Ende des Erregungs- und Überwachungsstromkreises mit der Erregerwicklung verbunden ist, und am anderen Ende das Messsignal der vom Leiter geführten Stromstärke abgegeben wird. Wenn der obenstehend beschriebene Stromwandler verwendet wird, kann mittels Zuhilfenahme des Erregungs- und Überwachungsstromkreises der Messumfang der Stromstärke oder der Messumfang der Frequenz leichter erweitert werden.

In einem Ausführungsbeispiel der vorliegenden Erfindung umfasst der Stromwandler weiterhin eine Messwicklung, die verwendet wird, um ein Messsignal zu liefern, und die Messvorrichtung umfasst weiterhin einen Messstromkreis, wobei der Messstromkreis mit der Messwicklung verbunden ist, und verwendet wird, um zu messen, ob der Wandler ordnungsgemäß funktioniert.

In einem Ausführungsbeispiel der vorliegenden Erfindung ist weiterhin ein Netzanschlussmodul enthalten, das verwendet wird, um die Stromzufuhr für den Erregungs- und Überwachungsstromkreis vorzunehmen oder um die Stromzufuhr für den Messstromkreis vorzunehmen.

### Beschreibung der Zeichnungen

Der untenstehende Text stellt in klarer und verständlicher Weise mittels Erklärungen und beigefügten Zeichnungen der bevorzugten Ausführungsbeispiele eine weiterführende Erklärung der oben beschriebenen Eigenschaften, technischen Merkmale, Vorteile und Umsetzungsverfahren der Erfindung dar, dabei ist:
Zeichnung 1 eine Strommessvorrichtung des Stands der Technik;
Zeichnung 2 eine schematische Darstellung eines Stromwandlers gemäß der Erfindung;
Zeichnung 3 eine Schnittzeichnung des in Zeichnung 2 dargestellten Wandlers in V-V-Richtung;
Zeichnung 4 eine schematische Darstellung einer Strommessvorrichtung gemäß der Erfindung.

### Erklärung der Nummerierung

1 Stromwandler; 2 Leiter; 3 Erregerwicklung; 4 Messwicklung; 5 Magnetkern; 6 Dichtmaterial; 7 Halterung; 8 Gehäuse; 10 Erregungs-und Überwachungsstromkreis; 11 Netzanschlussmodul; 12 Messstromkreis; 82 Wandler; 84 Verarbeitungskreislauf; 89 Erregungskreislauf; 812 Tiefpass.

### Ausführungsbeispiele

Um ein besseres Verständnis der technischen Eigenschaften, Ziele und Wirkung der vorliegenden Erfindung zu fördern, werden zunächst anhand der Zeichnungen konkrete Ausführungsbeispiele der vorliegenden Erfindung erklärt, in jeder Zeichnung stehen identische Ziffern für identische Bauteile.

In einem Magnetmodulationssystem, erhöht sich der Erregungsstrom I_{extDC} in Übereinstimmung mit einer Erhöhung des zu messenden Stroms I_{Δn}, die Beziehung zwischen ihnen wird durch die Spulenwindungszahl N des Wandlers bestimmt. Wenn der Erregungsstrom verringert werden soll, muss die Windungszahl N erhöht werden. Aber nach Erhöhung der Windungszahl N kann sich der Messumfang der Frequenz aufgrund der Senkung der Erregungsfrequenz verringern.

Durch Analyse und Forschung sind die Erfinder zu der nachstehenden Schlussfolgerung gekommen: Mehr Spulenwindungen N können die zur Erregung notwendige Stromstärke absenken, eine kleinere Querschnittsfläche AC und eine geringere gesättigte magnetische Flussdichte Bm können die Erregungsfrequenz auf einem bestimmten Wert aufrechterhalten. Insbesondere gilt, dass ein außerordentlich wichtiger Einfluss der Querschnittsfläche des Magnetkerns auf den Stromverbrauch des Systems existiert, wenn man die Querschnittsfläche des Magnetkerns vergleichsweise klein konstruieren kann, kann bei gleichem Stromverbrauch der Messumfang von Stromstärkengröße oder Frequenz leichter eine beachtliche Ausweitung erfahren.

Zum einen kann sich in Folge einer Vergrößerung der Dimensionen einer Strommessvorrichtung wie zum Beispiel einer Reststrom-Schutzvorrichtung (RCD) der größte Nenn-Ansprechdifferenzstrom (IDn) der RCD normalerweise ebenfalls in Abhängigkeit dazu vergrößern, und die Stromversorgungskapazität erhöht sich gleichfalls in Abhängigkeit dazu. Mittels eines Vergleichs des Verhältnisses der Quadratwurzel des Querschnitts des Magnetkerns zur Länge des Magnetkreises des Magnetkerns ergab sich anhand zahlreicher Messungen, dass, wenn dieser Wert 0,02 beträgt, und eine angemessene Anzahl an Spulenwindungen verwendet wird, der Wert der Spannungserhöhung des System-Stromverbrauchs 5 mA/A beträgt (das bedeutet, dass sich bei einer Erhöhung des Messstroms um jeweils 1 A der Stromverbrauch des Systems um 5 mA erhöht), wenn dieses Verhältnis kleiner ist als 0,02, erhöht sich der Verlust schrittweise.

Außerdem haben die Erfinder, um die gesättigte magnetische Flussdichte Bm zu senken, zahlreiche Messungen für die Auswahl des Legierungsmaterials zur Herstellung des Magnetkerns durchgeführt, solches Legierungsmaterial enthält gewöhnlich wenigstens Nickel und Eisen, wobei der Nickelgehalt wenigstens 30 % des Gesamtgewichts des Magnetkerns ausmacht, in einem Ausführungsbeispiel der vorliegenden Erfindung wurde der Magnetkern aus einem Legierungsmaterial hergestellt, bei dem der Nickelgehalt mehr als 50 % des Gesamtgewichts des Magnetkerns ausmachte.

Gleichzeitig ist die Biegsamkeit des oben erwähnten Legierungsmaterials vergleichsweise gut, was für die Herstellung von Magnetkernen mit einer Querschnittsfläche, die kleiner ist als die von herkömmlichen Magnetkernen des Stands der Technik, vorteilhaft ist.

Im Fall, dass die gesättigte Magnetische Flussdichte Bm und die Querschnittsfläche Ac beide relativ gering sind, kann bei gleichem Stromverbrauch der Messumfang von Stromstärke und Frequenz gleichermaßen eine beachtliche Ausweitung erfahren.

Zeichnung 2 ist eine schematische Darstellung eines Ausführungsbeispiels eines Stromwandlers gemäß der Erfindung, beim Wandler 1 wurde eine kreisförmige Struktur verwendet, eine solche Struktur ist relativ weit verbreitet, selbstverständlich kann auch eine quadratische oder eine andere ringförmige Abdichtstruktur zur Herstellung des Wandlers verwendet werden.

Das Innere des Stromwandlers 1 durchläuft wenigstens ein Leiter 2, der den zu messenden Strom führt, gleichzeitig umfasst der Wandler 1 weiterhin wenigstens eine Erregerwicklung 3, selbstverständlich kann er weitergehend noch eine Messwicklung 4 umfassen, die verwendet wird, um zu messen, ob der Wandler ordnungsgemäß funktioniert.

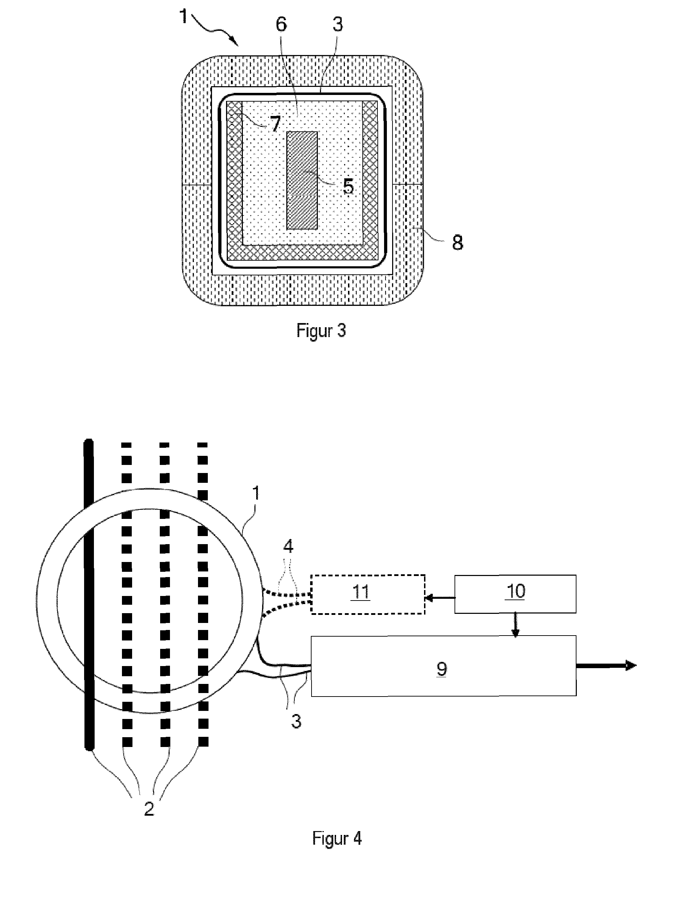

Zeichnung 3 ist eine Schnittzeichnung des in Zeichnung 2 dargestellten Wandlers in V-V-Richtung, in diesem Ausführungsbeispiel wird ersichtlich, dass der Wandler 1 einen Magnetkern 5 und eine um den Magnetkern 5 gewundene Erregerwicklung 3 umfasst.

Der Wandler 1 umfasst weiterhin eine Halterung 7, diese Halterung 7 verfügt über einen Aufnahme-Zwischenraum, die Halterung 7 kann dazu verwendet werden, die Erregerwicklung 3 zu stützen, gleichzeitig kann sie den Magnetkern 5 im Aufnahme-Zwischenraum ausrichten, und den Magnetkern 5 fixieren.

Weitergehend kann in einem anderen Ausführungsbeispiel zwischen der Halterung 7 und dem Magnetkern 5 noch mit Abdichtmaterial 6, zum Beispiel Material wie Harz oder Gummi etc., abgedichtet werden, was bewirkt, dass es nicht dazu kommen kann, dass der Magnetkern 5 im Inneren des Wandlers 1 schwankt.

Wieder weitergehend befindet sich in wieder einem anderen Ausführungsbeispiel außerhalb der Erregerwicklung 3 zur Abdeckung noch ein Gehäuse 8, wie in Zeichnung 3 dargestellt, kann der Wandler 1 weiterhin eine als Gehäuse 8 fungierende Schutzhülle umfassen, für das Gehäuse 8 kann wahlweise Carbonstahlmaterial verwendet werden, es kann wahlweise auch anderes Material verwendet werden, das in der Lage ist, vor Störungen von außen abzuschirmen.

Zeichnung 4 zeigt ein Beispiel einer Strommessvorrichtung, die den Stromwandler 1 verwendet, in einem vollständigen System.

In einem Ausführungsbeispiel der Strommessvorrichtung durchläuft, wie in Zeichnung 4 dargestellt, wenigstens ein den zu messenden Strom führender Leiter 2 das Innere des Wandlers 1, und der Wandler 1 hat wenigstens eine Erregerwicklung 3, die mit dem Erregungs- und Überwachungsstromkreis 10 verbunden ist, die konkrete Struktur des Erregungs- und Überwachungsstromkreises 10 kann der Patentanmeldung 102338822A entnommen werden. Der Erregungs- und Überwachungsstromkreis 10 gibt mittels Analogsignal oder Digitalsignal den abgelesenen Stromstärkewert an ein externes Objekt weiter.

In einem anderen Ausführungsbeispiel kann die vorliegende Erfindung eine Messwicklung 4 haben, die mit einem Messstromkreis 12 verbunden ist. Der Messstromkreis 12 wird verwendet, um ein Messsignal zu liefern, um dem Erregungs- und Überwachungsstromkreis 10 die Überprüfung zu erleichtern, ob der Wandler 1 ordnungsgemäß funktionieren kann.

In wieder einem anderen Ausführungsbeispiel umfasst die Vorrichtung weiterhin ein Netzanschlussmodul 11, das Netzanschlussmodul 11 kann durch einen von außen zugeführten Netzanschluss Energie erhalten und den Messstromkreis 12 oder den Erregungs- und Überwachungsstromkreis 10 mit Betriebsspannung versorgen.

Eine solche Strommessvorrichtung kann eine Reststrom-Schutzvorrichtung sein, selbstverständlich kann es sich auch um eine andere elektrische Anlage mit Stromstärkenmessfunktion handeln.

Es wird ersichtlich, dass die vorliegende Erfindung einen Stromwandler sowie eine den Wandler nutzende Messvorrichtung liefert, mittels der Querschnittsfläche Ac kann, wenn die Erregungsfrequenz f beibehalten wird und sich nicht ändert, mittels einer Erhöhung der Spulenwindungszahl N oder einer Verringerung der Erregungsspannung Vext eine Senkung des Stromverbrauchs im System erreicht werden; wenn die Spulenwindungszahl N beibehalten wird und sich nicht ändert, kann die Erregungsfrequenz f erhöht werden, somit erweitert sich der Messumfang der Frequenz im System, wenn die gesättigte magnetische Flussdichte Bm schrittweise verringert wird, kann der Messumfang der Stromstärke oder der Messumfang der Frequenz leichter erweitert werden, eine Nivellierung der beiden kann während der Anwendung mittels Schaltungskonfiguration gesteuert werden.

Im vorliegenden Text steht "schematisch" für "als Beispiel oder Erklärung fungierend", jegliche in diesem Text als "schematisch" beschriebenen Erläuterungen zu Zeichnungen und Ausführungsbeispielen stellen nicht das bevorzugte oder die meisten Vorzüge besitzende technische Konzept dar.

Die obenstehende Anordnung der Spezifizierungen dient lediglich zur konkreten Beschreibung der möglichen Ausführungsbeispiele der vorliegenden Erfindung, und wird keinesfalls dazu verwendet, den Schutzumfang der vorliegenden Erfindung zu beschränken, alle vom technischen Hauptinhalt der vorliegenden Erfindung nicht losgelösten entsprechenden Ausführungsbeispiele oder Änderungen sind Bestandteil des Schutzumfangs der vorliegenden Erfindung.

## Patentansprüche

1. Stromwandler (1), der einen Magnetkern (5) und wenigstens eine um den Magnetkern (5) gewundene Erregerwicklung (3) umfasst, **dadurch gekennzeichnet, dass** das Verhältnis der Quadratwurzel des Querschnitts des Magnetkerns (5) zur Länge des Magnetkreises des Magnetkerns (5) nicht größer ist als 0,02.

2. Stromwandler (1) gemäß der Beschreibung in Anspruch 1, **dadurch gekennzeichnet, dass** der Magnetkern (5) aus einer Legierung hergestellt ist, und die Legierung wenigstens Nickel und Eisen umfasst, wobei der Nickelgehalt wenigstens 30 % des Gesamtgewichts des Magnetkerns (5) ausmacht.

3. Stromwandler (1) gemäß der Beschreibung in Anspruch 1, **dadurch gekennzeichnet, dass** der Stromwandler (1) weiterhin eine Halterung (7) umfasst, diese Halterung (7) sich zwischen dem Magnetkern (5) und der Erregerwicklung (3) befindet, und diese Halterung (7) über einen Aufnahme-Zwischenraum verfügt, und sich der Magnetkern (5) in diesem Aufnahme-Zwischenraum befindet.

4. Stromwandler (1) gemäß der Beschreibung in Anspruch 3, **dadurch gekennzeichnet, dass** sich zwischen Magnetkern (5) und der Halterung (7) zur Abdichtung noch Abdichtmaterial (6) befindet.

5. Stromwandler (1) gemäß der Beschreibung in Anspruch 1, **dadurch gekennzeichnet, dass** sich außerhalb der Erregerwicklung (3) zur Abdeckung noch ein Gehäuse (8) befindet.

6. Stromwandler (1) gemäß der Beschreibung in Anspruch 1, **dadurch gekennzeichnet, dass** noch eine Messwicklung (4) enthalten ist, die verwendet wird, damit der Wandler (1) ein Messsignal übermittelt.

7. Stromwandler (1) gemäß der Beschreibung in Anspruch 1, **dadurch gekennzeichnet, dass** der Wandler (1) über eine kreisrunde Struktur oder eine quadratische Struktur verfügt.

8. Strommessvorrichtung, **dadurch gekennzeichnet, dass** sie einen Stromwandler (1) gemäß einem beliebigen der Ansprüche 1 bis 7 umfasst, wobei wenigstens ein stromführender Leiter (2) das Innere des Wandlers (1) durchläuft, und die Messvorrichtung weiterhin einen Erregungs-und Überwachungsstromkreis (10) umfasst, wobei ein Ende des Erregungs- und Überwachungsstromkreises (10) mit der Erregerwicklung (3) verbunden ist, und am anderen Ende das Messsignal der vom Leiter (2) geführten Stromstärke abgegeben wird.

9. Messvorrichtung gemäß der Beschreibung in Anspruch 8, **dadurch gekennzeichnet, dass** der Stromwandler (1) weiterhin eine Messwicklung (4) umfasst, die verwendet wird, um ein Messsignal zu liefern, und die Messvorrichtung weiterhin einen Messstromkreis (12) umfasst, wobei der Messstromkreis (12) mit der Messwicklung (4) verbunden ist, und verwendet wird, um zu messen, ob der Wandler (1) ordnungsgemäß funktioniert.

10. Messvorrichtung gemäß der Beschreibung in Anspruch 8, **dadurch gekennzeichnet, dass** sie weiterhin ein Netzanschlussmodul (11) umfasst, das verwendet wird, um die Stromzufuhr für den Erregungs- und Überwachungsstromkreis (10) vorzunehmen.

11. Messvorrichtung gemäß der Beschreibung in Anspruch 9, **dadurch gekennzeichnet, dass** sie weiterhin ein Netzanschlussmodul (11) umfasst, das verwendet wird, um die Stromzufuhr für den Messstromkreis (12) vorzunehmen.
